# EUROPÄISCHE PATENTSCHRIFT

(11) **EP 0 783 759 B1**
(45) Veröffentlichungstag und Bekanntmachung des Hinweises auf die Patenterteilung: **27.02.2002**
(21) Anmeldenummer: 95929766.4
(22) Anmeldetag: 06.09.1995
(51) Int. Cl.: H01B 11/00, H01B 7/08

(54) **MEHRLAGIGE ELEKTRISCHE LEITERPLATTE**
MULTI-LAYER ELECTRICAL CIRCUIT BOARD
CARTE DE CIRCUITS IMPRIMES A COUCHES MULTIPLES

(30) Priorität: 28.09.1994 DE 4434731
(43) Veröffentlichungstag der Anmeldung: 16.07.1997
(73) Patentinhaber: SIEMENS AKTIENGESELLSCHAFT, 80333 München (DE)
(72) Erfinder: BRAND, Uwe, D-81829 München (DE)
(86) Internationale Anmeldenummer: DE9501214
(87) Internationale Veröffentlichungsnummer: WO9610261

(56) Entgegenhaltungen:
- DE-A- 2 826 688
- FR-A- 1 034 170
- US-A- 4 381 420

## Beschreibung

Die Erfindung bezieht sich auf eine mehrlagige elektrische Leiterplatte mit zumindest zwei symmetrischen Leitungspaaren, die jeweils aus zwei einzelnen gedruckten, parallel zueinander verlaufenden Leiterbahnen bestehen.

Es ist bekannt, hochfrequenzführende Leitungen in einer Signallage der Leiterplatte anzuordnen, die zwischen Schirmlagen eingebettet ist. Dabei befinden sich die beiden Leitungen eines symmetrischen Leitungspaares in einer Ebene nebeneinander. Um ein Übersprechen zwischen zwei benachbarten Leitungspaaren zu verhindern, müssen diese in übereinanderliegende Signallagen verlegt werden. Dies führt zu einer höheren Anzahl von Signallagen, was die Leiterplattendicke vergrößert und die Herstellungskosten erhöht.

In der DE 6930062 U1 wird eine mehrlagige Leiterplatte mit zwei Leiterebenen beschrieben, die zwei symmetrische Leitungspaare aufweist, die jeweils aus zwei einzelnen gedruckten, zueinander parallel verlaufenden Leiterbahnen bestehen. Die einzelnen Leiterbahnen eines Paares liegen jeweils in der Mittelebene des anderen Leitungspaares.

Der Erfindung liegt die Aufgabe zugrunde, die Herstellungskosten der Leiterplatte zu verringern.

Diese Aufgabe wird durch die Erfindung gemäß Anspruch 1 gelöst. Ein symmetrisches Leitungspaar ist z.B. durch eine Hin- und Rückleitung eines Leitungszuges gebildet. Die Erfindung geht davon aus, daß die Mittelebene zwischen zwei Leitungen eines Leiterpaares elektromagnetisch mit Masse oder Nullpotential gleich ist. Diese Mittelebene steht senkrecht zur Ebene, die durch das Leitungspaar gebildet wird. Wird nun in diese Ebene ein zweites symmetrisches Leiterpaar gelegt, so wird dieses von dem ersten elektromagnetisch nur sehr gering beeinflußt und umgekehrt . Das Signalübersprechen ist erheblich geringer als zwischen zwei Leiterpaaren einer Ebene.

Von Vorteil ist es, die beiden Leiterebenen zwischen zwei Schirmebenen zu legen, wodurch das Übersprechen noch mehr verringert ist und wodurch nach außen abgehende Störstrahlungen verhindert werden. Durch den Wegfall einer Schirmlage zwischen den beiden Leiterpaaren wird die Anzahl der Lagen der Leiterplatte und der Herstellungsaufwand verringert. Bei einer günstigen Konfiguration ist z.B. die Leiterbahnbreite etwas geringer als der Abstand zwischen den beiden Leiterebenen, der Zwischenabstand zwischen zwei Leitern einer Ebene kann beispielsweise die Hälfte des Leiterebenenabstandes betragen.

Nach einer vorteilhaften Weiterbildung der Erfindung sind die beiden Leiterbahnen einer Ebene gegenüber den beiden Leiterbahnen der anderen Ebene in der Art eines Parallelogramms seitlich zueinander versetzt angeordnet und beträgt das Maß des seitlichen Versatzes ungefähr ein Fünftel des Abstandes der Leiterebenen. Eine experimentelle Überprüfung hat ergeben, daß bei diesen geometrischen Verhältnissen das Signalübersprechen besonders gering ist.

Im folgenden wird ein in der Zeichnung dargestelltes Ausführungsbeispiel der Erfindung näher erläutert.
- Figur 1: zeigt schematisiert einen Schnitt durch ein symmetrisches Leitungspaar mit den zwischen den Leitern verlaufenden Feldlinien,
- Figur 2: einen Schnitt durch eine Lage einer Leiterplatte mit zwei symmetrischen Leitungspaaren und zwei Schirmlagen,
- Figur 3: einen Schnitt durch die Leiterplatte nach Figur 2 mit seitlich zueinander versetzten Leitungspaaren.

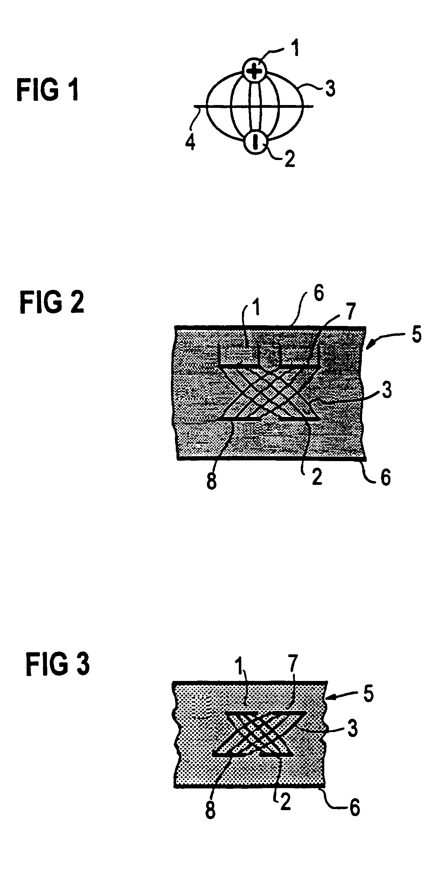

Nach Figur 1 besteht ein symmetrisches Leitungspaar aus einer Hinleitung 1 und einer Rückleitung 2 eines Leitungszuges, wobei zwischen den beiden Leitungen des Leitungspaares ein elektromagnetisches Feld aufgebaut ist, dessen Feldlinien 3 in einer Mittelebene 4 zwischen den beiden Leitungen einem Nullpotential entsprechen. Ein in dieser Ebene liegendes zweites Leitungspaar kann also im Idealfall vom ersten Leitungspaar elektromagnetisch nicht beeinflußt werden.

Nach Figur 2 sind in einer mehrlagigen Leiterplatte 5 zwei Signallagen mit elektrischen Leitern zwischen zwei Schirmlagen 6 angeordnet. Die beiden Leiter des ersten Leitungspaares 1, 2 sind auf die beiden, in unterschiedlichen Ebenen befindlichen Signallagen verteilt. Ein zweites Leitungspaar, das wie das erste Leitungspaare senkrecht zur dargestellten Schnittebene verläuft, ist so angeordnet, daß sich die Verbindungsachsen zwischen den Leitern 1 und 2 sowie 7 und 8 annähern im rechten Winkel kreuzen. Das bedeutet, daß sich jeweils ein Leitungspaar in der neutralen Mittelebene zwischen den beiden Leitern des anderen Leitungspaares befindet. Das Signalübersprechen zwischen den beiden Leitungspaaren wird dadurch erheblich verringert.

Nach Figur 3 sind die beiden Leiter der einen Signallage zu den beiden Leitern der anderen Signallage seitlich versetzt angeordnet. Der Versatz beträgt ungefähr ein Fünftel des Abstandes zwischen den beiden Signallagen. Bei dieser Anordnung wird das Signalübersprechen besonders wirksam verringert.

## Patentansprüche

1. Mehrlagige elektrische Leiterplatte (5) mit zumindest zwei Leiterebenen und mit zumindest zwei symmetrischen Leitungspaaren, die jeweils aus zwei einzelnen gedruckten, zueinander parallel verlaufenden Leiterbahnen (1 und 2, 7 und 8) bestehen,
wobei die einzelnen Leiterbahnen eines Paares jeweils in der Mittelebene des anderen Leiterpaares liegen,
wobei die beiden Leiterbahnen (1 und 2) zumindest eines der Leitungspaare in unterschiedlichen benachbarten Leitungsebenen verlaufen und
wobei die Leiterebene der Leiterbahnen eines zweiten Leiterpaares die Leiterebene des ersten Leiterpaares kreuzt,
**dadurch gekennzeichnet,**
**daß** die beiden Leiterbahnen (1 und 2) jeweils eines der in unterschiedlichen benachbarten Leitungsebenen verlaufenden Leitungspaare der Leiterplatte (5) seitlich zueinander versetzt verlaufend angeordnet sind,
**daß** in gleicher Weise angeordnete Leiterbahnen (7 und 8) des zweiten Leitungspaares in unmittelbarer Nähe des ersten Leitungspaares und in den Leiterebenen einander diagonal kreuzend angeordnet sind und
**daß** die einzelnen Leiterbahnen eines Paares jeweils in der Mittelebene zwischen den beiden Leiterbahnen des anderen Leitungspaares liegen.

2. Leiterplatte nach Anspruch 1,
**dadurch gekennzeichnet,**
**daß** die beiden Leiterbahnen (1, 7) einer Ebene gegenüber den beiden Leiterbahnen (2, 8) der anderen Ebene in der Art eines Parallelogrammes seitlich zueinander versetzt angeordnet sind und daß das Maß des seitlichen Versatzes ungefähr ein Fünftel des Abstandes zwischen den Leiterebenen beträgt.

## Claims

1. Multilayer electrical printed circuit board (5) having at least two conductor planes and having at least two symmetrical line pairs, each comprising two individual printed conductor tracks (1 and 2, 7 and 8) running parallel to one another,
the individual conductor tracks of one pair in each case lying in the central plane of the other conductor pair,
the two conductor tracks (1 and 2) of at least one of the line pairs running in different adjacent line planes, and
the conductor plane of the conductor tracks of a second conductor pair crossing the conductor plane of the first conductor pair,
**characterized**
**in that** the two conductor tracks (1 and 2) of in each case one of the line pairs of the printed circuit board (5) that run in different adjacent line planes are arranged such that they run laterally offset with respect to one another,
**in that** conductor tracks (7 and 8) of the second line pair that are arranged in the same way are arranged in direct proximity to the first line pair and such that they cross one another diagonally in the conductor planes, and
**in that** the individual conductor tracks of one pair in each case lie in the central plane between the two conductor tracks of the other line pair.

2. Printed circuit board according to Claim 1,
**characterized**
**in that** the two conductor tracks (1, 7) of one plane are arranged such that they are laterally offset with respect to one another in the manner of a parallelogram relative to the two conductor tracks (2, 8) of the other plane, and in that the extent of the lateral offset amounts to approximately one fifth of the distance between the conductor planes.

## Revendications

1. Carte de circuits imprimés à couches multiples (5) ayant au moins deux plans de conducteurs et ayant au moins deux paires de conducteurs symétriques qui sont constituées chacune de deux pistes conductrices (1 et 2, 7 et 8) imprimées et s'étendant parallèlement l'une à l'autre,
dans laquelle les pistes conductrices d'une paire se trouvent respectivement dans le plan médian de l'autre paire de conducteurs,
dans laquelle les deux pistes conductrices (1 et 2) d'au moins l'une des paires de conducteurs s'étendent dans des plans de conducteurs voisins différents, et
dans laquelle le plan de conducteurs des pistes conductrices d'une deuxième paire de conducteurs croise le plan de conducteurs de la première paire de conducteurs,
**caractérisée par le fait que**
les deux pistes conductrices (1 et 2) à chaque fois d'une des paires de conducteurs, s'étendant dans des plans de conducteurs voisins différents, de la carte de circuits imprimés (5) sont disposées décalées latéralement l'une par rapport à l'autre,
des pistes conductrices (7 et 8), disposées de la même manière, de la deuxième paire de conducteurs sont disposées à proximité immédiate de la première paire de conducteurs et selon un croisement en diagonale dans les plans de conducteurs, et
les pistes conductrices individuelles d'une paire se trouvent respectivement dans le plan médian entre les deux pistes conductrices de l'autre paire de conducteurs.

2. Carte de circuits imprimés selon la revendication 1,
**caractérisée par le fait que** les deux pistes conductrices (1, 7) d'un plan sont disposées par rapport aux deux pistes conductrices (2, 8) de l'autre plan avec un décalage latéral les unes par rapport aux autres comme une sorte de parallélogramme et que la dimension du décalage latéral vaut environ un cinquième de la distance entre les plans de conducteurs.
